# EUROPEAN PATENT APPLICATION

(11) **EP 2 199 049 A1**
(43) Date of publication of application: **23.06.2010**
(21) Application number: 08830689.9
(22) Date of filing: 09.09.2008
(51) Int. Cl.: B29C 33/38, B29C 59/02, C03C 3/06, G02B 5/18, H01L 21/027

(54) **TiO2-CONTAINING QUARTZ GLASS SUBSTRATE**

(30) Priority: 13.09.2007 JP 2007237989
(71) Applicant: Asahi Glass Company, Limited, Chiyoda-ku Tokyo 100-8405 (JP)
(72) Inventor: IKUTA, Yoshiaki, Tokyo 100-8405 (JP); IWAHASHI, Yasutomi, Tokyo 100-8405 (JP); OKAMURA, Kenji, Tokyo 100-8405 (JP)
(74) Representative: Müller-Boré & Partner Patentanwälte
(86) International application number: PCT/JP2008/066199
(87) International publication number: WO 2009/034954

(57) **Abstract**

An object of the present invention is to provide a TiO₂-containing quartz glass substrate which, when used as a mold base for nanoimprint lithography, can form a concavity and convexity pattern having a dimensional variation falling within ±10%. The invention relates to a TiO₂-containing quartz glass substrate: in which a coefficient of thermal expansion in the range of from 15 to 35°C is within ±200 ppb/°C; a TiO₂ concentration is from 4 to 9 wt%; and a TiO₂ concentration distribution, in a substrate surface on the side where a transfer pattern is to be formed, is within ±1 wt%.

## Description

### TECHNICAL FIELD

The present invention relates to a TiO₂-containing quartz glass substrate to be used as a mold base for nanoimprint lithography, which is used for the purpose of forming a fine concavity and convexity pattern having a dimension of 1 to 10 µm in a semiconductor device, an optical waveguide, a small optical element (a diffraction grating or the like), a biochip, a micro-reactor, or the like.

### BACKGROUND ART

As a method for forming a fine concavity and convexity pattern having a dimension of 1 to 10 µm on some substrate (e.g., a single-crystal substrate of Si, sapphire or the like, or an amorphous substrate of glass or the like), a method of using reduced projection exposure is currently common. As an inexpensive method alternative to this method, nanoimprint lithography has been investigated (see, e.g., Patent Document 1). According to the nanoimprint lithography, a fine concavity and convexity pattern can be formed on a substrate at a low cost as compared with conventional methods.
A process outline of the nanoimprint lithography is as follows:
(1) a light-curable resin layer or a thermosetting resin layer is formed on a substrate;
(2) a mold member (mold) having a desired concavity and convexity pattern (transfer pattern) is pressed against the resin layer on the substrate to transfer the concavity and convexity pattern on the resin layer; and
(3) the resin layer is allowed to cure by irradiation of ultraviolet light in the case of the light-curable resin or by heating in the case of the thermosetting resin, and then the mold is removed to obtain the desired fine concavity and convexity pattern on the substrate.

In photo-nanoimprint lithography where a light-curable resin is used as a curable resin, since a concavity and convexity pattern can be obtained by ultraviolet light irradiation alone, it gives high through-put and can prevent a dimensional change, etc. caused by temperature as compared with heat-cycle nanoimprint lithography where a thermosetting resin is used. Therefore, the photo-nanoimprint lithography is preferred. Particularly, in the mold for photo-nanoimprint lithography, there has been proposed a method of forming a light-blocking film (a metal film made of, for example, Cr or CrN) on the mold surface at the part (usually a convex part) where curing of the light-curable resin is not intended, to thereby prevent the light-curable resin at an unintended part from remaining on the substrate due to ultraviolet light irradiation (see, e.g., Patent Documents 2 and 3). Since such improvement cannot be realized in the heat-cycle nanoimprint lithography, the photo-nanoimprint lithography is excellent also from this viewpoint.

As a mold base for photo-nanoimprint lithography, it is common to use quartz glass owing to its excellent ultraviolet light transparency and chemical resistance. However, since the coefficient of thermal expansion of quartz glass at around room temperature is so high as about 500 ppb/°C and the glass lacks dimensional stability, it has been proposed to use a silica-titania glass containing titania in a ratio of from 2 to 15% by mass (see Patent Document 4). The titania-containing silica glass has such a low coefficient of linear expansion as 200 ppb/°C or less in the temperature range of from 20 to 35°C and also is excellent in dimensional stability, so that the titania-containing silica glass is thought to be preferable as a mold base for photo-nanoimprint lithography.

On the other hand, as a mold base for heat-cycle nanoimprint lithography, since an excellent dimensional stability upon heating is required in addition to chemical resistance, the material is required to have a low coefficient of thermal expansion and thus a glass having a low coefficient of thermal expansion or the like has been investigated.
A TiO₂-containing quartz glass such as the silica-titania glass described in Patent Document 4 is known to be an extremely low thermal expansion material having a coefficient of thermal expansion lower than that of quartz glass, and the coefficient of thermal expansion can be controlled by TiO₂ content in the glass, so that a zero expansion glass whose coefficient of thermal expansion is nearly zero is obtained. Therefore, the TiO₂-containing quartz glass has a preferable property as a material to be used as the mold base for heat-cycle nanoimprint lithography.

Patent Document 1: JP-A-2005-210093
Patent Document 2: JP-A-2004-104114
Patent Document 3: JP-A-2006-324268
Patent Document 4: JP-A-2006-267595

### DISCLOSURE OF THE INVENTION

The titania-silica glass in Patent Document 4 is low in thermal expansion and is excellent in dimensional stability, but dimensional accuracy of the transfer pattern (concavity and convexity pattern) to be formed for use as a mold base for nanoimprint lithography is not always stably obtained. With regard to this point, as a result of intensive studies, the present inventors have found out that a variation of titania concentration in the titania-silica glass is a cause thereof. Namely, the transfer pattern (concavity and convexity pattern) is formed by etching a flat base by some method: Here, since the titania-silica glass contains a titania component besides silica, chemical properties of the glass depend on the titania concentration and the etching rate at the formation of the transfer pattern (concavity and convexity pattern) depends on the titania concentration. Specifically, when the titania concentration in the titania-silica glass is higher, the etching rate becomes larger. Therefore, when a variation of the titania concentration in the titania-silica glass is present, the etching rate is fluctuated at the formation of the transfer pattern (concavity and convexity pattern) by etching, which leads to problems of generating a dimensional variation of the transfer pattern (concavity and convexity pattern) formed by etching, particularly a variation of the dimension in the vertical direction of the transfer pattern (concavity and convexity pattern), and thus decreasing the dimensional accuracy of the transfer pattern (concavity and convexity pattern).

The nanoimprint lithography is used for the purpose of forming a fine concavity and convexity pattern having a dimension of from 1 to 10 µm in a semiconductor device, an optical waveguide, a small optical element (diffraction grating or the like), a bio chip, a micro-reactor, or the like. When the fine concavity and convexity pattern is formed, it is required to suppress the dimensional variation of the concavity and convexity pattern within ±10%, more preferably within ±5%. Therefore, for the base for nanoimprint lithography, it is required to suppress the dimensional variation of the transfer pattern (concavity and convexity pattern) formed by etching within ±10%, more preferably within ±5%.

In order to solve the aforementioned problems of the conventional techniques, an object of the present invention is to provide a TiO₂-containing quartz glass substrate which, when used as a mold base for nanoimprint lithography, can form a transfer pattern (concavity and convexity pattern) excellent in dimensional accuracy, specifically a transfer pattern (concavity and convexity pattern) having a dimensional variation falling within ±10%.

### MEANS FOR SOLVING THE PROBLEMS

To achieve the above object, the present invention provides a TiO₂-containing quartz glass substrate to be used as a mold base for photo-nanoimprint lithography, having:
a coefficient of thermal expansion in the range of from 15 to 35°C of within ±200 ppb/°C;
a TiO₂ concentration of from 4 to 9 wt%; and
a TiO₂ concentration distribution, in a substrate surface on the side where a transfer pattern is to be formed, of within ±1 wt%.

Further, the present invention provides a TiO₂-containing quartz glass substrate to be used as a mold base for heat-cycle nanoimprint lithography, having:
a coefficient of thermal expansion in the range of from 15 to 200°C of within ±200 ppb/°C;
a TiO₂ concentration of from 6 to 9 wt%; and
a TiO₂ concentration distribution, in a substrate surface on the side where a transfer pattern is to be formed, of within ±1 wt%. In the present specification, the phrase "the TiO₂ concentration distribution is within ±1 wt%" means that a difference between the maximum value and the minimum value of the TiO₂ concentration is 2 wt% or less.

In the TiO₂-containing quartz glass substrate of the present invention, a TiO₂ concentration distribution, in a surface-neighboring region from the substrate surface to a depth of 50 µm on the side where a transfer pattern is to be formed, is preferably within ±1 wt%.

In the TiO₂-containing quartz glass substrate of the present invention, a fictive temperature distribution, in the substrate surface on the side where a transfer pattern is to be formed, is preferably within ±100°C. In the present specification, the phrase "the fictive temperature distribution is within ±100°C" means that a difference between the maximum value and the minimum value of the fictive temperature is 200°C or less.
In the TiO₂-containing quartz glass substrate of the present invention, a fictive temperature distribution, in the surface-neighboring region from the substrate surface to a depth of 50 µm on the side where a transfer pattern is to be formed, is preferably within ±10.0°C.

In order to alleviate the temperature dependency of the coefficient of thermal expansion, a halogen element may be incorporated into the TiO₂-containing quartz glass substrate of the invention so that the halogen concentration becomes 2,000 ppm or more. However, in that case, it is preferred to make the halogen concentration distribution in the substrate surface on the side where the transfer pattern is to be formed fall within ±2,000 ppm. In the specification, the phrase "the halogen concentration is within ±2,000 ppm" means that a difference between the maximum value and the minimum value of the halogen concentration is 4,000 ppm or less.
In this case, the halogen concentration distribution, in the surface-neighboring region from the substrate surface to a depth of 50 µm on the side where a transfer pattern is to be formed, is preferably within ±2,000 ppm.
In this case, the halogen element is preferably chlorine or fluorine.

### ADVANTAGES OF THE INVENTION

The TiO₂-containing quartz glass substrate of the invention has an extremely low coefficient of thermal expansion in the temperature range which a mold base may undergo during nanoimprint lithography (in the case of photo-nanoimprint lithography, at around room temperature (however, there is a case where the temperature of the mold base is elevated by ultraviolet light irradiation); and in the case of heat-cycle nanoimprint lithography, the temperature range from around room temperature to the curing temperature of the thermosetting resin). Therefore, the TiO₂-containing quartz glass substrate of the invention is excellent in shape stability against the temperature change which the mold base may undergo during nanoimprint lithography and thus is suitable as a mold base for nanoimprint lithography.
Moreover, the TiO₂-containing quartz glass substrate of the invention has an extremely small TiO₂ concentration distribution in a substrate surface on the side where the transfer pattern (concavity and convexity pattern) is to be formed and preferably an extremely small TiO₂ concentration distribution in the surface-neighboring region including the substrate surface. Therefore, the TiO₂-containing quartz glass substrate of the invention can suppress the generation of fluctuation of the etching rate at the formation of the transfer pattern (concavity and convexity pattern) by etching, and can form a transfer pattern (concavity and convexity pattern) having a high dimensional accuracy, specifically a transfer pattern (concavity and convexity pattern) having a dimensional variation falling within ±10%, preferably within ±5%. Accordingly, the TiO₂-containing quartz glass substrate is suitable as a mold base for nanoimprint lithography, particularly a mold base for photo-nanoimprint lithography.
Furthermore, by making the fictive temperature distribution in the substrate surface on the side where a transfer pattern (concavity and convexity pattern) is to be formed fall within ±100°C, preferably by making the fictive temperature distribution in the surface-neighboring region including the substrate surface fall within ±100°C, the TiO₂-containing quartz glass substrate of the invention can further suppress the generation of fluctuation of the etching rate at the formation of the transfer pattern (concavity and convexity pattern) by etching. Accordingly, the dimensional accuracy of the formed transfer pattern (concavity and convexity pattern) is further improved.
Additionally, by incorporating a halogen element so that the halogen concentration becomes 2,000 ppm or more, the TiO₂-containing quartz glass substrate of the invention can alleviate the temperature dependency of the coefficient of thermal expansion of the glass substrate. In this case, by making the halogen concentration distribution in the substrate surface on the side where a transfer pattern (concavity and convexity pattern) is to be formed fall within ±2,000 ppm, preferably by making the halogen concentration distribution in the surface-neighboring region including the substrate surface fall within ±2,000 ppm, the generation of fluctuation of the etching rate can be further suppressed at the formation of the transfer pattern (concavity and convexity pattern) by etching. Accordingly, the dimensional accuracy of the formed transfer pattern (concavity and convexity pattern) is further improved. BRIER DESCRIPTION OF THE DRAWINGS

[Fig. 1]

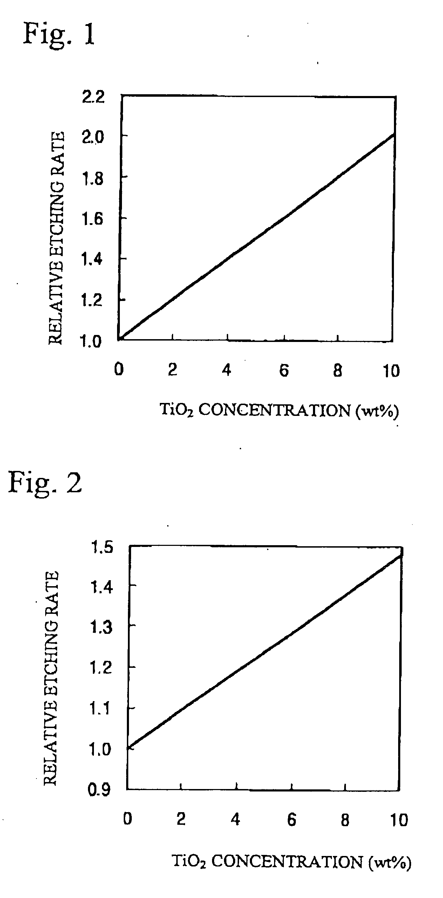

   Fig. 1 is a graph illustrating the TiO₂ concentration dependency of the etching rate in the case of the dry etching test.
[Fig. 2]
   Fig. 2 is a graph illustrating the TiO₂ concentration dependency of the etching rate in the case of the wet etching test.
[Fig. 3]

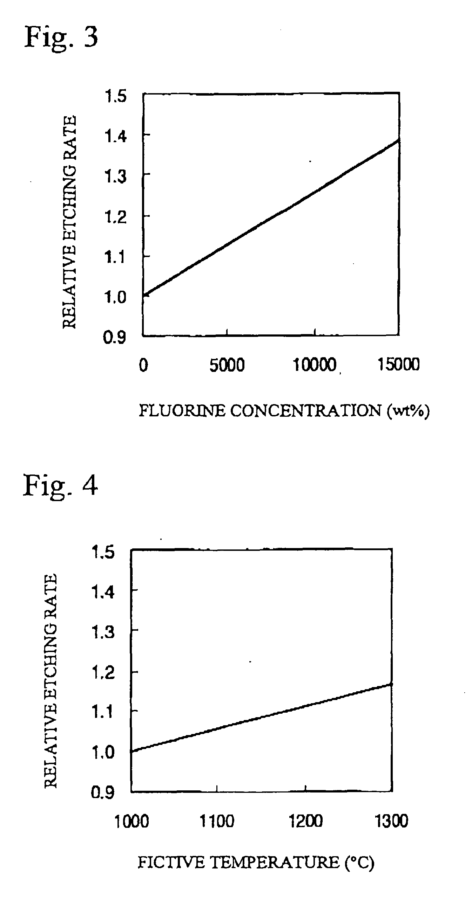

   Fig. 3 is a graph illustrating the halogen concentration dependency of the etching rate.
[Fig. 4]
   Fig. 4 is a graph illustrating the fictive temperature dependency of the etching rate.

### BEST MODE FOR CARRYING OUT THE INVENTION

The following will further explain the TiO₂-containing quartz glass substrate of the invention.
Since the TiO₂-containing quartz glass substrate of the invention is used as a mold base for nanoimprint lithography, it is required to be excellent in shape stability against a temperature change, more specifically shape stability against a temperature change in the temperature region which the glass substrate may undergo during the nanoimprint lithography. Here, the temperature region which the glass substrate may undergo varies depending on the kind of the nanoimprint lithography. Since a light-curable resin is allowed to cure by ultraviolet light irradiation in photo-nanoimprint lithography, the temperature region which the glass substrate may undergo is basically around room temperature. However, the temperature of the glass substrate may be locally elevated by ultraviolet light irradiation in some cases. In consideration of the local temperature elevation by ultraviolet light irradiation, the temperature region which the glass substrate may undergo is assumed to be the range of from 15 to 35°C.
The TiO₂-containing quartz glass substrate of the invention to be used as a mold base for photo-nanoimprint lithography has a coefficient of thermal expansion in the range of from 15 to 35°C being within ±200 ppb/°C. When the coefficient of thermal expansion in the range of from 15 to 35°C is within ±200 ppb/°C, the coefficient of thermal expansion of the glass substrate is extremely low in the temperature region which the glass substrate may undergo during the photo-nanoimprint lithography and thus the glass substrate is excellent in shape stability against a temperature change in the temperature region.
The size of the mold for photo-nanoimprint lithography is 70 mm square at most, and the size of the region for forming the concavity and convexity pattern (transfer pattern) is 50 mm square at most. For example, in the case where the temperature of the mold base having a coefficient of thermal expansion of 200 ppb/°C changes by 1°C, the size of the mold base varies by 100 nm per the region (50 mm square) for forming the concavity and convexity pattern (transfer pattern). Therefore, in the case where a fine concavity and convexity pattern (transfer pattern) having a dimension of from 1 to 10 µm is formed on the mold base, it is necessary to suppress the positional accuracy of the concavity and convexity pattern (transfer pattern) within 10% of the dimension of the concavity and convexity pattern, i.e., within from ±100 nm to ±1,000 nm. If the coefficient of thermal expansion in the range of from 15 to 35°C is within ±200 ppb/°C, when a fine concavity and convexity pattern (transfer pattern) is formed on the mold base, the positional accuracy of the concavity and convexity pattern (transfer pattern) can be suppressed within 10% of the concavity and convexity pattern (transfer pattern).
The TiO₂-containing quartz glass substrate of the invention to be used as the mold base for photo-nanoimprint lithography more preferably has a coefficient of thermal expansion in the range of from 15 to 35°C falling within ±100 ppb/°C.

On the other hand, in the case of heat-cycle nanoimprint lithography, since a thermosetting resin is allowed to cure by heating, the temperature region which the glass substrate may undergo is from around room temperature to the curing temperature of the thermosetting resin. The curing temperature of the thermosetting resin varies depending on the kind of the thermosetting resin. In the case of thermosetting resins (e.g., unsaturated polyester resins, epoxy resins, urethane resins, etc.) commonly used in the heat-cycle nanoimprint lithography, the curing temperature is usually from 150 to about 200°C.
The TiO₂-containing quartz glass substrate of the invention to be used as a mold base for heat-cycle nanoimprint lithography has a coefficient of thermal expansion in the range of from 15 to 200°C being within ±200 ppb/°C. When the coeffcient of thermal expansion in the range of from 15 to 200°C is within ±200 ppb/°C, the coefficient of thermal expansion of the glass substrate is extremely low in the temperature region which the glass substrate may undergo during the heat-cycle nanoimprint lithography and thus the glass substrate is excellent in shape stability against a temperature change in the temperature region.
In this connection, in the case of the heat-cycle nanoimprint lithography, since a heated mold is pressed against a substrate having a thermosetting resin layer formed thereon, the temperature of each of the mold and the substrate having the thermosetting resin layer formed thereon is elevated to some degree. Therefore, a difference of thermal expansion between the mold and the substrate having the thermosetting resin layer formed thereon becomes a problem. Here, as a material for the substrate having the thermosetting resin layer formed thereon, a low expansion glass having a coefficient of thermal expansion in the range of from 15 to 200°C being within ±200 ppb/°C is preferably used. When the TiO₂-containing quartz glass substrate of the invention is used as the mold, since the coefficient of thermal expansion is within ±200 ppb/°C in the temperature range which the mold may undergo during the heat-cycle nanoimprint lithography, i.e., in the temperature region from around room temperature to the curing temperature of the thermosetting resin, there does not arise any problem caused by the difference of thermal expansion between the mold and the substrate having the thermosetting resin layer formed thereon.
The TiO₂-containing quartz glass substrate of the invention to be used as the mold base for heat-cycle nanoimprint lithography more preferably has a coefficient of thermal expansion in the range of from 15 to 200°C falling within ±100 ppb/K.

For making the coefficient of thermal expansion in the range of from 15 to 35°C falling within ±200 ppb/°C, the TiO₂-containing quartz glass substrate of the invention to be used as the mold base for photo-nanoimprint lithography has a TiO₂ concentration of from 4 to 9 wt%. When the TiO₂ concentration exceeds 9 wt%, TiO₂ crystals precipitate and the coefficient of thermal expansion in the range of from 15 to 35°C becomes lower than -200 ppb/°C. When the TiO₂ concentration is less than 4 wt%, the coefficient of thermal expansion in the range of from 15 to 35°C becomes larger than +200 ppb/°C.
In the TiO₂-containing quartz glass substrate of the invention to be used as the mold base for photo-nanoimprint lithography, the TiO₂ concentration is preferably from 5 to 8 wt%. In that case, the coefficient of thermal expansion in the range of from 15 to 35°C falls within ±100 ppb/°C.
On the other hand, for making the coefficient of thermal expansion in the range of from 15 to 200°C falling within ±200 ppb/°C, the TiO₂-containing quartz glass substrate of the invention to be used as the mold base for heat-cycle nanoimprint lithography has a TiO₂ concentration of from 6 to 9 wt%. When the TiO₂ concentration exceeds 9 wt%, TiO₂ crystals precipitate and the coefficient of thermal expansion in the range of from 15 to 200°C becomes lower than -200 ppb/°C. When the TiO₂ concentration is less than 6 wt%, the coefficient of thermal expansion in the range of from 15 to 200°C becomes larger than +200 ppb/°C.
In the TiO₂-containing quartz glass substrate of the invention to be used as the mold base for heat-cycle nanoimprint lithography, the TiO₂ concentration is preferably from 7 to 8 wt%. In that case, the coefficient of thermal expansion in the range of from 15 to 200°C falls within ±100 ppb/°C.

The TiO₂-containing quartz glass substrate of the invention has; a TiO₂ concentration being within the above-described range (4 to 9 wt% (for the mold base for photo-nanoimprint lithography) or 5 to 8 wt% (for the mold base for heat-cycle nanoimprint lithography)), and also has a TiO₂ concentration distribution in the substrate surface on the side where a transfer pattern is to be formed being within ±1 wt%.
At the formation of a transfer pattern (concavity and convexity pattern) on a TiO₂-containing quartz glass substrate by etching, the etching rate depends on the TiO₂ concentration. Specifically, when the TiO₂ concentration in the TiO₂-containing quartz glass substrate is higher, the etching rate becomes larger. Therefore, when a variation of the TiO₂ concentration is present in the TiO₂-containing quartz glass substrate, the etching rate is fluctuated at the formation of the transfer pattern (concavity and convexity pattern) by etching. As a result, a dimensional variation of the formed transfer pattern (concavity and convexity pattern) is generated, and hence the dimensional accuracy of the formed transfer pattern (concavity and convexity pattern) decreases.
In the TiO₂-containing quartz glass substrate of the invention, in addition to the TiO₂ concentration being in the above-described range, by making the TiO₂ concentration distribution fall within ±1 wt%, the fluctuation of the etching rate is suppressed at the formation of the transfer pattern (concavity and convexity pattern) by etching, and the dimensional accuracy of the formed transfer pattern (concavity and convexity pattern) is improved.
However, in the TiO₂-containing quartz glass substrate of the invention, it is not necessary that the TiO₂ concentration distribution is within ±1 wt% over the whole substrate. Of the TiO₂-containing quartz glass substrate, the part where the variation of the TiO₂ concentration may cause a problem is a part where the transfer pattern (concavity and convexity pattern) is to be formed by etching. Among the dimensions of the transfer pattern (concavity and convexity pattern) formed on the mold for nanoimprint lithography, the dimension particularly influenced by the fluctuation of the etching rate is a dimension in the vertical direction of the transfer pattern (concavity and convexity pattern). The dimension in the vertical direction of the transfer pattern (concavity and convexity pattern) is usually from 50 nm to 50,000 nm (50 µm), although the dimension depends on the transfer pattern (concavity and convexity pattern) to be formed by nanoimprint lithography. Therefore, of the TiO₂-containing quartz glass substrate, if the TiO₂ concentration distribution in the substrate surface on the side where a transfer pattern is to be formed is within ±1 wt%, the fluctuation of the etching rate is suppressed at the formation of the transfer pattern (concavity and convexity pattern) by etching, and the dimensional accuracy of the formed transfer pattern (concavity and convexity pattern) is improved. Incidentally, in order to effectively bring out the above advantages, the TiO₂ concentration distribution in a surface-neighboring region from the surface to a depth of 50 µm of the transfer pattern-forming side of the substrate is preferably within ±1 wt%.
In the TiO₂-containing quartz glass substrate of the present invention, the TiO₂ concentration distribution in the substrate surface on the side where a transfer pattern is to be formed is preferably within ±0.5 wt%. Furthermore, in the TiO₂-containing quartz glass substrate in the present invention, the TriO₂ concentration distribution in the surface-neighboring region from the substrate surface to a depth of 50 µm on the side where a transfer pattern is to be formed is preferably within ±0.5 wt%.

In this connection, the TiO₂ concentration distribution in the substrate surface can be obtained by determining the TiO₂ concentration in the substrate surface using XRF (X-ray Fluorescence analysis). The analytical depth by XRF is about 50 nm and the phrase "the TiO₂ concentration distribution in the substrate surface" in the present specification means the concentration distribution in the region from the surface to a depth of about 50 nm. On the other hand, the TiO₂ concentration distribution in the surface-neighboring region from the surface to a depth of about 50 µm can be obtained by obtaining the TiO₂ concentration in the substrate surface by the above-described procedure, and thereafter repeating such a procedure of: etching the substrate surface in a prescribed extent with an Ar ion or the like; the Ti concentration is determined by using various analytical means; and further etching the substrate surface in a prescribed extent.

In the invention, owing to the following points, the fluctuation of the etching rate at the formation of the transfer pattern (concavity and convexity pattern) by etching can be further suppressed.
The etching rate of a TiO₂-containing quartz glass substrate also depends on the fictive temperature of the TiO₂-containing quartz glass substrate. When the fictive temperature of the TiO₂-containing quartz glass substrate is higher, the etching rate becomes larger. Therefore, when a variation of the fictive temperature of the TiO₂-containing quartz glass substrate is present, the etching rate is fluctuated and a dimensional variation of the formed transfer pattern (concavity and convexity pattern) is generated at the formation of the transfer pattern (concavity and convexity pattern) by etching, so that the dimensional accuracy of the formed transfer pattern (concavity and convexity pattern) decreases. Therefore, in the TiO₂-containing quartz glass substrate of the invention, the fictive temperature distribution in the substrate surface on the side where the transfer pattern (concavity and convexity pattern) is to be formed is preferably small. Specifically, the fictive temperature distribution in the substrate surface on the side where the transfer pattern (concavity and convexity pattern) is to be formed is preferably within ±100°C.
When the fictive temperature distribution in the substrate surface on the side where the transfer pattern (concavity and convexity pattern) is to be formed is within ±100°C, the fluctuation of the etching rate can be further suppressed at the formation of the transfer pattern (concavity and convexity pattern) by etching, and the dimensional accuracy of the formed concavity and convexity pattern can be further improved. Incidentally, in order to effectively bring out the above advantages, the fictive temperature distribution in the surface-neighboring region from the surface to a depth of 50 µm of the transfer pattern-forming side of the substrate is preferably within ±100°C.
In this connection, the fictive temperature of the TiO₂-containing quartz glass substrate means the fictive temperature determined from the position of the absorption peak at a wave number of around 2260 cm⁻¹ using an infrared spectrophotometer according to a literature (A. Agarwal, K. M. Dabis and M. Tomozawa, "A simple IR spectroscopic method for determining fictive temperature of silica glass", J. Non-Cryst. Solids., 185, 191-198 (1995)). The measuring depth by the above-noted measuring method is about 10 µm and the phrase "the fictive temperature distribution in the substrate surface" in the specification means the fictive temperature distribution in the region from the surface to a depth of about 10 µm.

The TiO₂-containing quartz glass substrate in the present invention, the fictive temperature distribution, in the surface on the side where a transfer pattern is to be formed, is preferably within ±40°C, more preferably within ±10°C, and particularly preferably within ±5°C.
Furthermore, the fictive temperature distribution, in a surface-neighboring region from the substrate surface to a depth of 50 µm on the side where a transfer pattern is to be formed, is preferably within ±40°C, more preferably within ±10°C, and particularly preferably within ±5°C.

In this connection, the fictive concentration distribution in the substrate surface and the fictive temperature distribution in the surface-neighboring region from the substrate surface to a depth of 50 µm can be determined from the fictive temperature in the substrate surface determined according to the aforementioned method, or the fictive temperature in the surface-neighboring region from the substrate surface to a depth of 50 µm.
Moreover, the fictive temperature distribution can be determined based on the ratio I495/I440 of scattering peak intensity I495 at 495 cm⁻¹ to scattering peak intensity I440 at 440 cm⁻¹ and the ratio I606/I440 of scattering peak intensity I606 at 606 cm⁻¹ to scattering peak intensity I440 at 440 cm⁻¹ in a laser Raman spectrum. According to this method, the fictive temperature at any place in the substrate can be measured.

In order to alleviate the temperature dependency of the coefficient of thermal expansion, a halogen element may be incorporated into the TiO₂-containing quartz glass substrate of the invention in an amount of 2,000 ppm or more.
The halogen element herein means a fluorine element, a chlorine element, a bromine element, an iodine element, or the like. Of these, a fluorine element or a chlorine element is preferred for the reason of availability of the raw material and the reason that since the atomic size thereof is relatively small, the structural strain induced by doping the element into the glass is small. A fluorine element is more preferred.
When the halogen element is incorporated for the purpose of alleviating the temperature dependency of the coefficient of thermal expansion, it is more preferred to incorporate it in such an amount that the halogen concentration becomes 5,000 ppm or more.

However, when the halogen element is incorporated, it is necessary not to generate the fluctuation of the etching rate at the formation of the transfer pattern (concavity and convexity pattern) by etching. The etching rate of the TiO₂-containing quartz glass substrate also depends on the concentration of the halogen element contained in the TiO₂-containing quartz glass substrate, and the etching rate becomes larger when the concentration of the halogen element is higher. Therefore, when a variation of the concentration distribution of the halogen element is present in the TiO₂-containing quartz glass substrate, the etching rate is fluctuated and a dimensional variation of the formed transfer pattern (concavity and convexity pattern) is generated at the formation of the transfer pattern (concavity and convexity pattern) by etching, so that the dimensional accuracy of the formed transfer pattern (concavity and convexity pattern) decreases. Thus, in the case where a halogen element is incorporated into the TiO₂-containing quartz glass substrate, the halogen concentration distribution in the substrate surface on the side where a transfer pattern is to be formed is preferably set to be within ±2,000 ppm. When the halogen concentration distribution in the substrate surface on the side where a transfer pattern is to be formed is within ±2,000 ppm, the fluctuation of the etching rate can be further prevented at the formation of the transfer pattern (concavity and convexity pattern) by etching, and the dimensional accuracy of the formed transfer pattern (concavity and convexity pattern) can be further improved. Incidentally, in order to effectively bring out the above advantages, the halogen concentration distribution, in the surface-neighboring region from the substrate surface to a depth of 50 µm on the side where a transfer pattern is to be formed, is preferably within ±2,000 ppm.

In the case where the halogen element is incorporated into the TiO₂-containing quartz glass substrate, the halogen concentration distribution in the substrate surface on the side where a transfer pattern (concavity and convexity pattern) is to be formed is more preferably within ±1,000 ppm.
Further, the halogen concentration distribution in the surface-neighboring region from the substrate surface to a depth of 50 µm on the side where a transfer pattern is to be formed, is more preferably within ±1,000 ppm.

In this connection, the halogen concentration distribution in the substrate surface and the halogen concentration distribution in the surface-neighboring region from the substrate surface to a depth of 50 µm can be determined by measuring the halogen concentration in the substrate surface or the halogen concentration in the surface-neighboring region from the substrate surface to a depth of 50 µm by a known method. In the case where the halogen element is a fluorine element, the fluorine concentration in the TiO₂-containing quartz glass substrate can be determined by, for example, using XPS (ESCA, X-ray photoelectron spectroscopy). The measuring depths by the above measuring methods are each from 2 to 3 nm, and the phrase "the halogen concentration distribution in the substrate surface" means the halogen concentration distribution in the region from the surface to a depth of 2 to 3 nm.

In the case of the TiO₂-containing quartz glass substrate to be used as the mold base for photo-nanoimprint lithography, internal transmittance toward ultraviolet light to be used at the photo-nanoimprint lithography is preferably high. Specifically, the internal transmittance toward ultraviolet light at a wavelength of 365 nm is preferably 50%/cm or more, more preferably 70%/cm or more, and further preferably 90%/cm or more.

For the purpose of manufacturing the TiO₂-containing quartz glass substrate of the invention, the following manufacturing method can be adopted.
Step (a):
   Using a seed rod made of quartz glass (e.g., the seed rod described in JP-B-63-24973) as a base material which is rotating on its axis at a certain constant rate, TiO₂-SiO₂ glass fine particles obtained through flame hydrolysis of an Si precursor and a Ti precursor each serving as a glass-forming raw material are deposited and grown on the base material, thereby forming a porous TiO₂-SiO₂ glass body. The glass-forming raw material is not particularly limited so far as it is a raw material capable of being gasified. Examples of the Si precursor include: halogenated silicon compounds which include chlorides such as SiCl₄, SiHCl₃, SiH₂Cl₂, and SiH₃Cl, fluorides such as SiF₄, SiHF₃, and SiH₂F₂, bromides such as SiBr₄ and SiHBr₃, and iodides such as SiI₄; and alkoxysilanes represented by RₙSi(OR)₄₋ₙ (where R represents an alkyl group having from 1 to 4 carbon atoms and n represents an integer of from 0 to 3). Examples of the Ti precursor include: halogenated titanium compounds such as TiCl₄ and TiBr₄; and alkoxytitaniums represented by RₙTi(OR)₄₋ₙ (where R represents an alkyl group having from 1 to 4 carbon atoms and n represents an integer of from 0 to 3). Also, as the Si precursor and the Ti precursor, a compound of Si and Ti such as a silicon titanium double alkoxide can be used. Also, as the base material, not only a rod-form base material but also a plate-form base material may be used.

Step (b):
   The porous TiO₂-SiO₂ glass body is subjected to temperature elevation to the transparent vitrification temperature to achieve transparent vitrification, thereby obtaining a transparent TiO₂-SiO₂ glass body. The transparent vitrification means a state where the porous glass body is densified to such an extent that a void cannot be confirmed by an optical microscope, and the transparent vitrification temperature means a temperature at which the porous glass body can be densified to such an extent that a void cannot be confirmed by an optical microscope. The transparent vitrification temperature is usually from 1,400 to 1,700°C and, especially preferably from 1,450 to 1,650°C. As the atmosphere, an atmosphere of 100% of an inert gas such as helium or an atmosphere containing an inert gas such as helium as a main component is preferred. With regard to the pressure, a reduced pressure or normal pressure can be applicable. Particularly, in the case of normal pressure, helium gas can be used. Moreover, in the case of a reduced pressure, 13,000 Pa or lower is preferred. Here, "Pa" means not a gauge pressure but an absolute pressure.

Step (c):
   The transparent TiO₂-SiO₂ glass body obtained in Step (b) is heated at a temperature of the softening point or higher and formed in a desired shape, thereby obtaining a formed TiO₂-SiO₂ glass body. The forming temperature is preferably from 1,500 to 1,800°C. When the temperature is lower than 1,500°C, since the viscosity of the TiO₂-SiO₂ glass is high, deformation due to own weight does not substantially proceed. Also, the growth of cristobalite which is a crystal phase of SiO₂, or the growth of rutile or anatase each of which is a crystal phase of TiO₂ occurs, thereby causing so-called devitrification. When the forming temperature is higher than 1,800°C, sublimation of SiO₂ cannot be neglected.

Step (d):
   The formed TiO₂-SiO₂ glass body obtained in Step (c) is kept at a temperature of from 600 to 1,200°C for 1 hour or more and then subjected to an annealing treatment for decreasing the temperature to 500°C or lower at a cooling rate of 20°C/hr or lower, thereby controlling calcination temperature of the TiO₂-SiO₂ glass. After decreasing the temperature to 500°C or lower, natural cooling can be adaptable. In this case, the atmosphere is preferably an atmosphere of 100% of an inert gas such as helium, argon or nitrogen, an atmosphere containing such an inert gas as a main component, or an air atmosphere, and the pressure is preferably a reduced pressure or normal pressure.

As a method for making the TiO₂ concentration distribution of the TiO₂-containing quartz glass substrate to be manufactured fall within ±1 wt%, any known method to be used at the manufacture of a quartz glass body having a high homogeneity in composition can be applied. For example, there may be mentioned a method of homogenizing the temperature of each procedure in the above step (a), a method of speeding up the rotation rate of the base in the step (a), a method of enlarging the size of the formed TiO₂-SiO₂ glass body in the step (c) and cutting out a portion having a small TiO₂ concentration distribution to obtain a TiO₂-containing quartz glass substrate, and the like method.

As a method for controlling the fictive temperature distribution within ±100°C, it is sufficient that, after the TiO₂-containing quartz glass is kept at a prescribed temperature within the range of from 800 to 1,200°C for 1 hour or more, in the step (d), to make the fictive temperature of the TiO₂-containing quartz glass nearly equal to the kept temperature, the glass is slowly cooled to a temperature lower than the kept temperature by about 200 to 400°C at a slow rate of 15°C/hr or lower so that temperature distribution is not generated in the interior of the TiO₂-containing quartz glass, and then, is rapidly cooled at a relatively rapid rate of 15°C/hr or higher.

For the manufacture of the TiO₂-containing quartz glass containing a fluorine element as the halogen element, this may be achieved by keeping the porous TiO₂-SiO₂ glass body obtained in the step (a) in a fluorine-containing atmosphere for a prescribed time, thereby obtaining a porous TiO₂-SiO₂ glass body containing a fluorine element. The fluorine-containing atmosphere is preferably an inert gas atmosphere containing from 0.1 to 100 % by volume of a fluorine-containing gas (e.g., SiF₄, SF₆, CHF₃, CF₄, C₂F₆, C₃F₈, and F₂). Under the atmosphere, it is preferred to keep the glass body at a pressure of from 10,000 to 100,000 Pa (about 1 atm) at room temperature or a high temperature of the transparent vitrification temperature or lower for from several ten minutes to several hours. The use of a temperature equal to or higher than the transparent vitrification temperature is not preferred because the densification of the porous TiO₂-SiO₂ glass body proceeds so that it becomes hard to incorporate the fluorine element into the interior of the porous TiO₂-SiO₂ glass body.
When it is intended to lower the temperature of the atmosphere in the case of obtaining the same fluorine concentration, this may be obtained by prolonging the keeping time and keeping the glass body for 5 to several ten hours.

For example, when SiF₄ is used as the fluorine-containing atmosphere, the treating temperature and the treating time may be set as follows in accordance with the fluorine concentration of the porous TiO₂-SiO₂ glass body to be obtained.
When it is intended to regulate the fluorine concentration to 2,000 ppm or more and less than 5,000 ppm, this may be achieved by keeping the glass body in an inert gas atmosphere containing from 1 to 10% by volume of SiF₄ at 500 to 1,000°C for from 1 to several ten hours. When it is intended to regulate the fluorine concentration to from 5,000 to 10,000 ppm, this may be achieved by keeping the glass body in an inert gas atmosphere containing 5 to several ten percent by volume of SiF₄ at 1,000 to 1,300°C for 2 to several ten hours.
In this connection, it is preferred that the TiO₂-SiO₂ glass body is placed under a reduced pressure (preferably 13,000 Pa or lower, particularly 1,300 Pa or lower), and then fluorine is introduced therein until normal pressure to achieve a fluorine-containing atmosphere, since this allows the fluorine element to be homogeneously incorporated into the porous TiO₂-SiO₂ glass body for a short period of time.

Alternatively, the porous TiO₂-SiO₂ glass body containing a fluorine element can be obtained by using a precursor containing fluorine as at least one of the Si precursor and the Ti precursor in the step (a).

Examples of a method of making the halogen concentration distribution in the TiO₂-containing quartz glass fall within ±2,000 ppm in the case of manufacturing the TiO₂-containing quartz glass containing a fluorine element as the halogen element include a method of kneading the glass body under heating in the range of from 1,500 to 1,700°C or higher by a horizontal zone melting method (FZ method) following the above step (b), and a method of heating the glass body at a temperature of 1,500 to 1,700°C or higher to achieve deformation due to own weight in a prescribed direction to form it in a desired shape.

### EXAMPLES

The following will further illustrate the invention with reference to Examples.

### (Example 1)

In the present Example, in order to investigate the relation between the TiO₂ concentration and the etching rate of the TiO₂-containing quartz glass substrate, by performing the step (a) with changing the ratio of the Si precursor to the Ti precursor at the preparation of the TiO₂-containing quartz glass according to the procedures of the aforementioned steps (a) to (d), TiO₂-containing quartz glass blocks having different TiO₂ concentrations (wt%) were prepared. A sample was cut out from the center of each of the TiO₂-containing quartz glass blocks and the following two kinds of etching tests were carried out.

### [Dry Etching Test]

Reactive ion etching with SF₆ was carried out at room temperature. On each sample, an etching rate (µm/min) was determined.

### [Wet Etching Test]

Wet etching was performed using hydrofluoric acid (5 wt%, room temperature). On each sample, an etching rate (µm/min) was determined.
Moreover, in order to investigate the etching rate of a quartz glass having a TiO₂ concentration of 0 wt%, a quartz glass block containing no TiO₂ was prepared by a flame hydrolysis method, a sample was cut out from the center of the quartz glass block, and the dry etching test and the wet etching test were carried out.
The results of the etching tests were plotted, the ordinate being the etching rate (relative etching rate) and the abscissa being the TiO₂ concentration (wt%), so that the TiO₂ concentration dependency of the etching rate was investigated. The results are shown in Figs. 1 and 2. Fig. 1 illustrates the TiO₂ concentration dependency of the etching rate at the dry etching test and Fig. 2 illustrates the TiO₂ concentration dependency of the etching rate at the wet etching test. In this connection, in Figs. 1 and 2, the etching rate is shown as a relative etching rate, the etching rate of the quartz glass having TiO₂ of 0 wt% being regarded as 1.
As is clear from Figs. 1 and 2, in order to suppress the fluctuation of the etching rate within ±5% and suppress the dimensional variation of the transfer pattern (concavity and convexity pattern) formed by etching within ±5%, it can be confirmed that the TiO₂ concentration distribution should be suppressed within ±1 wt%, preferably within ±0.5 wt%,

### (Example 2)

In the present Example, in order to investigate the relation between the halogen concentration and the etching rate in the TiO₂-containing quartz glass substrate containing a halogen element, TiO₂-containing quartz glass blocks containing fluorine in different concentrations (fluorine concentration: 0 to 15,000 ppm, TiO₂ concentration: 7%) were prepared, a sample was cut out from the center of each of the TiO₂-containing quartz glass blocks, the wet etching test was carried out using hydrofluoric acid (39 wt%, room temperature), and the halogen concentration dependency of the etching rate was investigated in the same manner as in Example 1. The results are shown in Fig. 3. In Fig. 3, the etching rate is shown as a relative etching rate, the etching rate of the quartz glass having a fluorine concentration of 0 ppm being regarded as 1. In this connection, the TiO₂-containing quartz glass blocks containing fluorine in different concentrations were obtained, at the preparation of the TiO₂-containing quartz glass according to the procedures of the steps (a) to (d), by keeping the porous TiO₂-SiO₂ glass body obtained in the step (a) at a temperature of from room temperature to 1,200°C for 2 hours under a fluorine-containing atmosphere of SiF₄/O₂ = 10/90 vol% to form a porous TiO₂-SiO₂ glass body containing a fluorine element. Moreover, as the TiO₂-containing quartz glass block having a fluorine concentration of 0%, the block prepared in Example 1 was used.
As is clear from Fig. 3, in order to suppress the fluctuation of the etching rate within ±5% and suppress the dimensional variation of the transfer pattern (concavity and convexity pattern) formed by etching within ±5%, it can be confirmed that the halogen concentration distribution (fluorine concentration distribution) should be suppressed within ±2,000 ppm.

### (Example 3)

In the present Example, in order to investigate the relation between the fictive temperature and the etching rate of the TiO₂-containing quartz glass substrate, TiO₂-containing quartz glass blocks having different fictive temperatures (fictive temperature: 1,000 to 1,300°C, TiO₂ concentration: 7%) were prepared by changing the kept temperature in step (d) at the preparation of the TiO₂-containing quartz glass according to the procedures of the steps (a) to (d), a sample was cut out from the center of each of the TiO₂-containing quartz glass blocks, the wet etching test was carried out using hydrofluoric acid (39 wt%, room temperature), and the fictive temperature dependency of the etching rate was investigated in the same manner as in Example 1. The results are shown in Fig. 4. In Fig. 4, the etching rate is shown as a relative etching rate, the etching rate of the quartz glass having a fictive temperature of 1,000°C being regarded as 1.
As is clear from Fig. 4, in order to suppress the fluctuation of the etching rate within ±5% and suppress the dimensional variation of the transfer pattern (concavity and convexity pattern) formed by etching within ±5%, it can be confirmed that the fictive temperature distribution should be suppressed within ±100°C.

While the invention has been described in detail and with reference to specific embodiments thereof, it will be apparent to one skilled in the art that various changes and modifications can be made therein without departing from the spirit and scope thereof.
The present application is based on Japanese Patent Application No. 2007-237989 filed on September 13, 2007, and the contents.are incorporated herein by reference.

## Claims

1. A TiO₂-containing quartz glass substrate to be used as a mold base for photo-nanoimprint lithography, having:
a coefficient of thermal expansion in the range of from 15 to 35°C of within ±200 ppb/°C;
a TiO₂ concentration of from 4 to 9 wt%; and
a TiO₂ concentration distribution, in a substrate surface on the side where a transfer pattern is to be formed, of within ±1 wt%.

2. A TiO₂-containing quartz glass substrate to be used as a mold base for heat-cycle nanoimprint lithography, having:
a coefficient of thermal expansion in the range of from 15 to 200°C of within ±200 ppb/°C;
a TiO₂ concentration of from 6 to 9 wt%; and
a TiO₂ concentration distribution, in a substrate surface on the side where a transfer pattern is to be formed, of within ±1 wt%.

3. The TiO₂-containing quartz glass substrate according to claim 1 or 2, having a TiO₂ concentration distribution, in a surface-neighboring region from the substrate surface to a depth of 50 µm on the side where a transfer pattern is to be formed, of within ±1 wt%.

4. The TiO₂-containing quartz glass substrate according to any one of claims 1 to 3 having, a fictive temperature distribution, in the substrate surface on the side where a transfer pattern is to be formed, of within ±100°C.

5. The TiO₂-containing quartz glass substrate according to claim 4, having a fictive temperature distribution, in the surface-neighboring region from the substrate surface to a depth of 50 µm on the side where a transfer pattern is to be formed, of within ±100°C.

6. The TiO₂-containing quartz glass substrate according to any one of claims 1 to 5 having: a halogen concentration of 2,000 ppm or more; and a halogen concentration distribution, in the substrate surface on the side where a transfer pattern is to be formed, of within ±2,000 ppm.

7. The TiO₂-containing quartz glass substrate according to claim 6, having a halogen concentration distribution, in the surface-neighboring region from the substrate surface to a depth of 50 µm on the side where a transfer pattern is to be formed, of within ±2,000 ppm.

8. The TiO₂-containing quartz glass substrate according to claim 6 or 7, wherein the halogen element is chlorine or fluorine.
